# FASCICULE DE BREVET EUROPEEN

(11) **EP 1 011 133 B1**
(45) Date de publication et mention de la délivrance du brevet: **30.06.2010**
(21) Numéro de dépôt: 99403134.2
(22) Date de dépôt: 14.12.1999
(51) Int. Cl.: H01L 21/56, H01L 23/31

(54) **Composant microélectronique CMS enrobé, notamment pour un dispositif médical implantable actif, et son procédé de fabrication**
Eingekapseltes mikroelektronisches SMD Bauelement, insbesondere für eine aktive implantierbare medizinische Vorrichtung und Herstellungsverfahren
Encapsulated microelectronic SMD component, especially for an active implantable medical device and method for its manufacture

(30) Priorité: 14.12.1998 FR 9815759
(43) Date de publication de la demande: 21.06.2000
(73) Titulaire: ELA MEDICAL, 92541 Montrouge (FR); Tronic's Microsystems, 38054 Grenoble (FR)
(72) Inventeur: Van Campenhout, Yves, 94190 Villeneuve Saint Georges (FR); Gilet, Dominique, 92160 Antony (FR); Legay, Thierry, 91640 Fontenay Les Briis (FR); Bono, Hubert, 38580 Haute Jarrie (FR)
(74) Mandataire: Dupuis-Latour, Dominique

(56) Documents cités:
- DE-A- 19 702 186
- DE-A- 19 712 551
- US-A- 4 613 891
- US-A- 5 714 800
- PATENT ABSTRACTS OF JAPAN vol. 098, no. 005, 30 avril 1998 (1998-04-30) -& JP 10 012765 A (ANAM IND CO INC), 16 janvier 1998 (1998-01-16) -& US 5 858 815 A (YOUNG WOOK HEO ET AL) 12 janvier 1999 (1999-01-12)
- VAL C M: "New chip scale package for medical applications: "plip-chip"" , PROCEEDINGS. 1996 INTERNATIONAL SYMPOSIUM ON MICROELECTRONICS (SPIE VOL.2920), 1996 INTERNATIONAL SYMPOSIUM ON MICROELECTRONICS, MINNEAPOLIS, MN, USA, 8-10 OCT. 1996 , 1996, RESTON, VA, USA, MICROELECTRON. SOC, USA, PAGE(S) 236 - 242 XP002113822ISBN: 0-930815-48-3 * le document en entier *

## Description

La présente invention concerne la technologie des circuits microélectroniques, plus particulièrement la technologie connue sous le nom de "CSP" (*Chip Scale Packaging*) dans laquelle le composant final réalisé s'étend sur une surface qui n'excède pas la taille de la puce ; en d'autres termes, l'enrobage de la puce pour réaliser le composant n'augmente pas la surface occupée par le composant sur le substrat qui le recevra.

Cette technologie est particulièrement avantageuse dans les domaines où la miniaturisation des circuits est un paramètre essentiel, comme dans celui des circuits de stimulateurs cardiaques ou autres dispositifs médicaux actifs implantables.

Une telle technique est par exemple décrite dans le WO-A-93/24956, dont la demanderesse est co-titulaire et qui décrit un procédé de fabrication d'un composant dont une face de la puce est complètement recouverte d'une couche d'enrobage de résine et porte une série de métallisations reliées à des plots de contact de la puce, ces plots étant noyés sous la couche de résine.

La technique décrite dans ce document permet d'opérer un enrobage collectif applicable globalement à la plaquette ("*wafer*") avant sa découpe, ce qui minimise le surcoût unitaire appliqué à chaque puce.

Cependant, dans cette technique la résine d'enrobage couvre l'intégralité de la plaquette, ce qui peut engendrer deux types de difficultés :
- En premier lieu, les plaquettes produites aujourd'hui étant de taille croissante (évolution des diamètres de 4, 5, 6, 8 jusqu'à 12 pouces), la contrainte globale générée sur la plaquette par le durcissement de la résine, qui est très dure une fois polymérisée, peut voiler cette plaquette, voire même provoquer des fissures, cassures ou clivages.
- En second lieu, la résine est en contact avec la partie active des circuits électroniques gravés sur les différentes puces et peut, à long terme, laisser filtrer des contaminations ioniques ou pollutions chimiques diverses. En effet, à la différence des technologies "*chip carrier*" où la puce est complètement isolée dans un boîtier scellé rempli d'un gaz neutre tel que l'azote, la résine ne constitue ici qu'un frein, pas une barrière, aux agressions du milieu extérieur et peut en conséquence réduire la fiabilité à long terme du micromotif électronique, qui n'est pas totalement isolé.

Pour remédier à ces difficultés, il a été proposé (Val CM "New Chip Scale Package for Medical Applications: «Plip-Chip»", Proceedings 1996 International Symposium on Microelectronics (SPIE Vol. 2920), 8-10 Oct. 1996, Reston, VA, USA, Microelectronics Society US, pp. 236-242, XP 002113822) de rapporter sur la puce un capot de silicium, avec à la périphérie des fils enrobés pour la prise de connexion aux plages de contact de la puce.

La présente invention a pour but de proposer un procédé perfectionné de réalisation d'un tel type de composant.

Le procédé de l'invention est du type générique indiqué plus haut, et il est caractérisé par les étapes exposées à la revendication 1. Les sous-revendications 2 à 7 présentent des mises en oeuvre avantageuses de ce procédé.

L'invention couvre également un composant CMS du type générique correspondant à l'article de Val et la précité, et comprenant les éléments caractéristiques énoncés dans la revendication 8. Les sous-revendications 9 et 10 indiquent des formes de réalisation particulières de ce composant.

Les figures 1 et 2 sont des vues en coupe partielle agrandie de la plaquette enrobée, illustrant respectivement une étape intermédiaire du procédé et le résultat final obtenu.

La figure 3 est une vue en plan de la plaquette enrobée obtenue par le procédé de l'invention, avant découpe en composants individuels.

Sur les figures, où les mêmes références numériques désignent des éléments identiques, la référence 10 désigne une plaquette de matériau semiconducteur, par exemple de silicium, que l'on peut désigner "plaquette active", portant un certain nombre de micromotifs électroniques gravés et destinée à former des composants individuels 12 après séparation le long de lignes de découpe 14.

Chaque composant comporte une puce pourvue d'une pluralité de plots de contacts ("*pads*") 16, qui sont des plages métallisées affleurant la surface de la plaquette 10.

Essentiellement, l'invention propose de réaliser un capotage physique de la plaquette active 10 par le scellement d'une plaque 18, ci-après désignée "capot", qui peut être par exemple (mais pas nécessairement) une plaquette de silicium, constituant alors une "plaquette passive" scellée sur la plaquette active 10.

Pour permettre l'accès aux plots de contact 16, le capot 18 est gravé profondément, de part en part, en 20, afin de pratiquer des lumières en regard des plots 16 et permettre la prise de connexion à ces derniers. Pour isoler complètement la plaquette active 10 du milieu environnant et la protéger des éventuelles contaminations chimiques, les connexions électriques aux plots de contact 16 seront ensuite engluées dans une résine isolante, sous atmosphère inerte, de la manière que l'on décrira ci-dessous plus en détail.

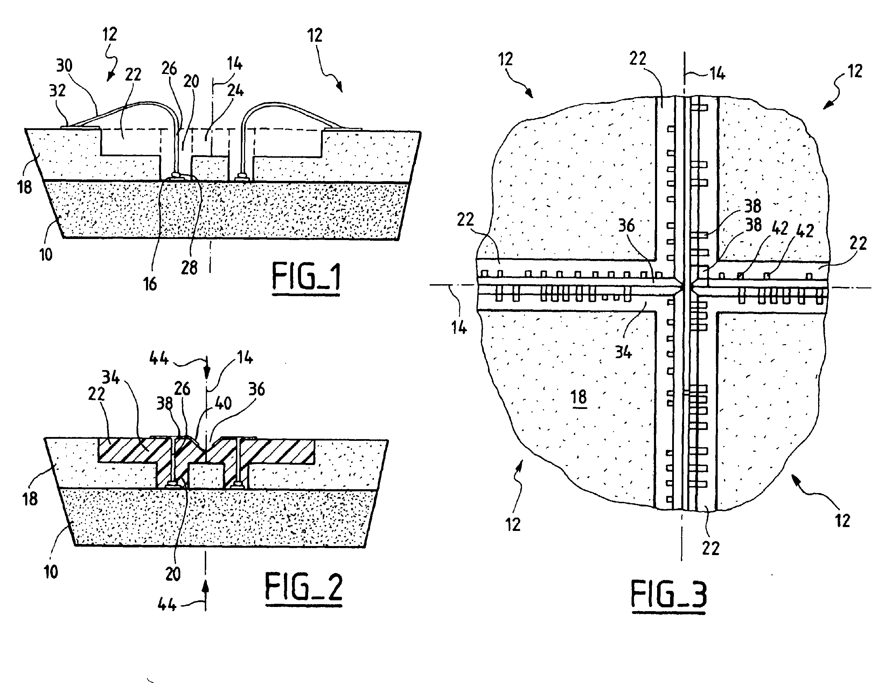

Plus précisément, la première étape du procédé consiste à microphotolithographier un capot 18 de façon à y créer, d'une part, des lumières 20 et, d'autre part, une tranchée périphérique 22 contenant l'ensemble de ces lumières 20, ceci sur une partie seulement de l'épaisseur du capot 18 et le long d'un ou plusieurs côtés de chaque composant 12 (les plots de contact 16 pouvant être situés eux-mêmes sur un ou plusieurs des côtés du composant 12, donnant ainsi sur la plaquette un motif de quadrillage (comme illustré par exemple en plan figure 3) ou de hachurage de tranchées 22.

On notera que les tranchées 22 de deux composants adjacents 12 sont, comme illustrées sur les figures, jointives en 24, de manière à permettre, comme on le verra plus loin, un bon écoulement de la résine qui sera coulée dans ces tranchées.

Le capot ainsi microphotolithographié (l'étape de microphotolithographie étant de préférence une étape préalable), le capot 18 est scellé sur la plaquette active 10. Ce scellement peut être notamment réalisé par un adhésif, par exemple un adhésif photoimageable, afin de définir un cordon périphérique sur le pourtour de chaque puce (l'adhésif pouvant éventuellement être également déposé, par exemple en croisillons, sur la partie centrale des puces si l'on souhaite augmenter l'adhérence).

L'adhésif choisi est bien entendu un adhésif compatible avec le silicium de la plaquette 10 afin d'éviter toute création de contraintes à l'interface plaquette/capot lors de cycles thermiques. Le capot n'étant pas en contact étroit avec la puce, sauf à l'endroit du cordon d'adhésif, l'opération de scellement est pratiqué sous atmosphère inerte, par exemple d'azote, pour protéger le micromotif électronique de toute éventuelle contamination chimique.

Bien entendu, le scellement du capot 18 sur la plaquette active 10 est opéré en respectant un positionnement précis tel que les plots de contact 16 se situent tous en regard d'une lumière 20 permettant d'accéder à ces derniers au travers du capot 18. Pour permettre ce positionnement précis, on peut en particulier utiliser le même masque pour la réalisation de la plaquette 10 et celle du capot, par exemple utiliser le masque de passivation de la plaquette 10 comme masque de gravure des lumières 20 dans le capot 18.

L'opération suivante consiste à réaliser les reprises de contact sur les plots 16, au travers des lumières 20.

Une première technique qui peut être utilisée, et qui correspond à l'exemple illustré, est celle exposée dans le WO-A-93/24956 précité. Cette technique consiste à relier des fils 26 traversant la lumière 20 d'une part aux plots de contact 16 par une bille fusible 28, ces fils 26 se terminant à leur autre extrémité par une queue 30 provisoirement soudée sur une métallisation 32 prévue à cet effet en surface supérieure du capot 18 après avoir réalisé des boucles (qui seront par la suite supprimées, comme on l'expliquera plus loin).

Une autre technique de reprise de contact sur la puce active consiste, par une technique connue en elle-même de dépôt et gravure, à déposer des métallisations sur les flancs des lumières 20 et des tranchées 22. Si l'on utilise pour le capot 18 un matériau conducteur tel que le silicium, il est nécessaire d'isoler auparavant ces flancs par dépôt d'une couche de passivation appropriée.

Une fois effectuée l'opération de reprise de contact, la structure présente la configuration illustrée figure 1.

L'étape suivante consiste à couler dans les lumières 20 et les tranchées 22 une résine d'enrobage 34, cette résine étant coulée suivant la direction des tranchées de sorte que la résine remplisse les lumières 20 et englue les fils d'interconnexion 26.

La résine coulée dans les tranchées est un matériau polymérisable tel qu'un polyimide, un polymère époxy, etc. susceptible d'être coulé localement et durci *in situ,* par exemple par exposition aux UV ou passage en température. Après polymérisation, le matériau durci, bien que rigide, présente néanmoins une souplesse suffisante, notamment du fait de la faible épaisseur sur laquelle elle est déposée dans la tranchée, pour ne générer qu'une contrainte minimale, insusceptible de voiler la plaquette 10.

Incidemment, il y a lieu de préciser que le terme d"'enrobage" qui pourra être utilisé dans la présente description ne doit pas être interprété dans un sens restrictif suggérant un enveloppement complet de la puce du composant ; ce terme ne se réfère qu'à la technologie particulière employée (*"coating"*) où la résine peut n'être appliquée, comme ici, que localement, en périphérie du composant.

L'ensemble plaquette 10/capot 18 est ensuite poli de façon à ôter l'excès de résine et la partie du fil dépassant du niveau supérieur de la tranchée. La résine 34 affleure alors la surface supérieure du capot 18, l'extrémité du fil 26 débouchant à la surface de la résine.

Il est éventuellement possible de réaliser dans la résine 34, par exemple par meulage, un sillon 36 destiné à former ultérieurement sur l'arête du composant 12 un biseau permettant (de manière en elle-même bien connue) le contrôle visuel de la soudure lorsque ce composant sera monté sur son substrat hôte.

La face supérieure du capot est ensuite métallisée, puis gravée pour réaliser des plots de contact 38 qui permettront le report du composant final obtenu ; dans le cas où l'on a formé un sillon 36, ces plots 38 peuvent déborder en 40 dans ce sillon afin de permettre un meilleur étalement de la soudure au moment du montage du composant sur son substrat hôte.

Sur la vue en plan de la figure 3, on peut voir les différentes métallisations émergeantes, avec les métallisations 38 formées sur la résine en surface du capot, ainsi que des points 42 en contact avec des conducteurs reliés à des plots de la puce. Ces points 42, qui ne sont pas prolongés à l'extérieur par une métallisation, peuvent être par exemple utilisés pour opérer un test sous pointes de la plaquette, avant découpe en composants individuels, ce test pouvant être opéré aussi bien avant qu'après enrobage de la plaquette.

Dans la variante illustrée figure 3, on notera que les métallisations 38 (contacts de report sur le substrat hôte) sont distribués en périphérie du composant. Cette caractéristique n'est cependant pas limitative, et il est par exemple possible d'avoir des contacts de report distribués sur la surface du capot, en prévoyant un reroutage entre, d'une part, les parties émergeantes des conducteurs 26 situées en périphérie du composant, et, d'autre part, des contacts de report situés dans la région centrale du capot, et généralement de plus grandes dimensions.

Dans ce dernier cas, on peut prévoir de déposer des billes de métal fusibles sur les contacts de report, ce qui permettra de souder le composant sur son substrat hôte sans apport de soudure. Cette technique dite "BGA" (*Ball Grid Array*) permet, dans le cas d'un nombre important de contacts, de répartir ceux-ci selon une grille dont le pas, par exemple de 0,8 mm, est notablement supérieur au pas des plots de contact de la puce, typiquement de 0,2 mm, évitant ainsi les problèmes liés à des plots de contact trop proches.

Enfin, la plaquette est découpée en composants individuels (suivant la ligne 44 de la figure 2), de manière à obtenir des composants CSP individuels 12 en forme de puces enrobées montables sur un substrat à la manière d'un composant CMS, le biseau sur l'arête inférieure (provenant de la réalisation du sillon 36) permettant le contrôle visuel de la soudure sur le substrat hôte.

## Revendications

1. Un procédé d'enrobage de puces électroniques, ce procédé étant un procédé collectif appliqué à une plaquette portant une pluralité de puces individuelles et à partir de laquelle seront formés, après découpe de la plaquette, une pluralité correspondante de composants, le composant résultant étant un composant CMS de type CSP,
le procédé comprend les étapes suivantes:
a) obtenir une plaquette (10) sur laquelle est gravée ladite pluralité de puces individuelles (12), avec pour chacune une série de plots de contact (16) disposés sur au moins l'un des côtés de la puce,
b) sceller sur cette plaquette, dans des régions prédéterminées de chaque composant, un capot (18) comportant des lumières (20) au droit de chacun des plots des puces sous-jacentes, ces lumières étant des trous traversant le capot de part en part et autorisant un accès aux plots correspondants,
c) réaliser dans le capot, sur une partie seulement de l'épaisseur de celui-ci, un quadrillage, ou hachurage, de tranchées (22) suivant le côté, ou respectivement la périphérie, de chaque puce sous-jacente, avec les différentes lumières débouchant toutes dans une tranchée,
d) mettre en place dans les lumières des liaisons électriquement conductrices aux plots, ces liaisons (26) émergeant sur la face supérieure du capot,
e) couler une résine d'enrobage (34) dans les lumières et les tranchées,
f) polir et métalliser le capot, et
g) découper la plaquette ainsi préparée en composants individuels.

2. Le procédé de la revendication 1, dans lequel le capot est une plaquette de même nature et de même dimensions que la plaquette sur laquelle sont gravées les puces, notamment une plaquette de silicium.

3. Le procédé de la revendication 1, dans lequel le scellement de l'étape b) est opéré par dépôt ou gravure d'un cordon d'adhésif défini en périphérie de chaque puce et, éventuellement, déposé également dans la région centrale de chaque puce.

4. Le procédé de la revendication 1, dans lequel les liaisons électriquement conductrices mises en place à l'étape d) comportent des fils métalliques soudés sur les plots au travers des lumières.

5. Le procédé de la revendication 1, dans lequel les liaisons électriques conductrices mises en place à l'étape d) comportent des conducteurs métalliques formés par dépôt et gravure d'une métallisation en contact avec les plots et s'étendant sur les flancs des lumières et le fond et les flancs des tranchées, cette métallisation étant électriquement isolée de la plaquette et du capot.

6. Le procédé de la revendication 1, dans lequel les liaisons électriques conductrices mises en place à l'étape d) émergent à la surface du capot en des contacts de report (38) distribués en périphérie du composant.

7. Le procédé de la revendication 1, dans lequel les liaisons électriques conductrices mises en place à l'étape d) émergent à la surface du capot en des points d'un motif d'interconnexion aboutissant à des contacts de report distribués en région centrale du composant.

8. Un composant CMS avec une puce comportant un enrobage externe permettant son report sur un substrat, cet enrobage portant en surface une pluralité de métallisations externes reliées électriquement, au travers du matériau d'enrobage, aux plots de la puce situés en vis-à-vis et noyés dans l'épaisseur du matériau d'enrobage, le composant enrobé étant un composant de type CSP ayant dans le sens de la longueur et de la largeur sensiblement les mêmes dimensions que celles de la puce avant enrobage,
composant dans lequel la puce (12) est recouverte sur sa surface d'un capot (18) scellé sur la puce dans des régions prédéterminées de celle-ci, et comportant également une tranchée (22) formée le long d'au moins l'un des côtés du composant portant les plots, et dans lequel l'enrobage (34) est formé dans le capot et sur une partie réduite de la surface de celui-ci, dans la région de la tranchée,
composant **caractérisé en ce que** :
- le capot comporte des lumières (20) au droit de chacun des plots (16) sous-jacents, ces lumières étant des trous traversant le capot de part en part et autorisant un accès aux plots correspondants ;
- la tranchée (22) est formée sur une partie seulement de l'épaisseur du capot ; et
- les différentes lumières débouchent toutes dans la tranchée.

9. Le composant de la revendication 8, dans lequel le capot est de même nature que la plaquette sur laquelle sont gravées les puces, notamment une plaquette de silicium.

10. Le composant de la revendication 8, dans lequel le capot est scellé par un cordon d'adhésif défini en périphérie de chaque puce et, éventuellement, déposé également dans la région centrale de chaque puce.

## Claims

1. A process for encapsulating electronic chips, wherein said process is a collective process applied to a wafer carrying a plurality of individual chips and from which are formed, after dicing of the wafer, a corresponding plurality of components, the resulting component being a CSP-type SMD-component, said process comprising following steps :
a) Obtaining a wafer (10) on which said plurality of individual chips (12) is etched, with for each of them a series of bump contacts (16) disposed on at least one side of the chip,
b) Sealing onto said wafer, in predetermined regions of each component, a lid (18) comprising apertures (20) in the extension of the underlying bump contacts, wherein said apertures are through-holes through the lid and allow accessing to corresponding bump contacts,
c) Performing in the lid, on only a part of its thickness, a dicing or a hatching of trenches (22) following respectively the side or the periphery of each underlying chip, with the various apertures ending all in one trench,
d) Inserting in the apertures electrically conductive connections to the bump contacts, wherein said connections (26) emerge on the upper surface of the lid,
e) Casting an encapsulating resin (34) into apertures and trenches,
f) Polishing and metallizing the lid, and
g) Dicing the so processed wafer into individual components.

2. The process according to Claim 1, wherein the lid is a wafer of the same kind and dimensions as the wafer onto which chips are etched, and especially a silicon wafer.

3. The process according to Claim 1, wherein said sealing of Step d) is performed through deposit or etching an adhesive strip that is defined on the periphery of each chip and possibly is also deposited into the central region of each chip.

4. The process according to Claim 1, wherein the electrically conductive connections inserted in Step d) comprise metallic wires that are sealed onto the bump contacts through the apertures.

5. The process according to Claim 1, wherein the electrically conductive connections inserted in Step d) comprise metallic conductors that are produced through depositing and etching of a metallization pattern in contact with the bump contacts and extending on the flanks of the apertures and on the bottom and the flanks of the trenches, wherein said metallization pattern is electrically isolated from the wafer and the lid.

6. The process according to Claim 1, wherein the electrically conductive connections inserted in Step d) project from the lid surface at transfer contacts (38) distributed on component periphery.

7. The process according to Claim 1, wherein the electrically conductive connections inserted in Step d) project from lid surface at points of an interconnection pattern ending in transfer contacts distributed in the central region of the component.

8. A SMD component with a chip comprising an external encapsulation layer allowing its transfer onto a substrate, wherein said encapsulation layer carries on its surface a plurality of external metallization patterns that, through the encapsulating material, are electrically connected to the opposite bump contacts of the chip that are embedded into the encapsulating material's thickness, wherein the encapsulated component is a CSP-type component having in the longitudinal and the cross directions essentially the same dimensions as the chip before encapsulating ; wherein the chip is on its surface covered by a lid (18) that is sealed onto the chip in predetermined regions of the latter, and also comprises a trench (22) formed along at least one of the sides of the component carrying the bump contacts, and in which the encapsulation (34) is formed in the lid and on a reduced part of its surface in the region of the trench,
said component being **characterized in that :**
- the lid comprises apertures (20) in the extension of each of the underlying bump contacts (16), said apertures being through-holes through the lid and allowing accessing to corresponding bump contacts ;
- the trench (22) is formed only on a part of lid thickness ; and
- the various apertures end all into the trench.

9. The component according to Claim 8, wherein the lid is of the same kind as the wafer onto which are etched the chips, especially a silicon wafer.

10. The component according to Claim 8, wherein the lid is sealed through an adhesive strip defined on the periphery of each chip, and possibly is also deposited into the central region of each chip.

## Patentansprüche

1. Ein Verfahren zur Einkapselung von elektronischen Chips, wobei genanntes Verfahren ein kollektives Verfahren ist, das für einen eine Vielzahl von individuellen Chips tragenden Wafer verwendet ist und ab welches nach der Zerteilung des Wafers eine entsprechende Vielzahl von Bauelementen gebildet wird, wobei das resultierende Bauelement ein SMD-Bauelement des Typs CSP ist, wobei das Verfahren folgende Schritte umfasst :
a) Versorgung eines Wafers (10), auf welchem genannte Vielzahl von individuellen Chips (12) geätzt wird, wobei für jeden Chip eine Reihe von auf wenigstens einer der Seiten des Wafers angeordneten Kontaktklötzen (16) vorgesehen ist,
b) Versiegeln auf diesen Wafer, in vorbestimmten Bereichen jedes Bauelements, Versiegeln einer Öffnungen (20) in der Verlängerung jedes Klotzes der darunterliegenden Chips umfassenden Haube (18), wobei genannte Öffnungen Löcher sind, die durch die Haube von einer Seite zur anderen verlaufen und die einen Zugang zu den entsprechenden Klötzen erlaubt,
c) Herstellung in der Haube und nur auf einem Teil ihrer Dicke, einer Zerteilung bzw. eines Schraffierens von Gräben (22), die der Seite bzw. der Peripherie jedes darunterliegenden Chips folgen, wobei alle verschiedenen Öffnungen in einen Graben münden,
d) Einsetzen von elektrizitätsleitenden Verbindungen mit den Klötzen in die Öffnungen" wobei genannte Verbindungen (26) aus der Oberseite der Haube austreten,
e) Giessen eines Einkapselungsharzes (34) in die Öffnungen und in die Gräben,
f) Polieren und Metallisierung der Haube, und
g) Zerteilung des so vorbereiteten Wafers zu individuellen Bauelementen.

2. Das Verfahren gemäss Anspruch 1, in welchem die Haube eine Scheibe ist, dessen Natur und Abmessungen dieselben sind, wie die Scheibe, insbesondere eine Siliziumscheibe, auf welcher die Chips geätzt sind.

3. Das Verfahren gemäss Anspruch 1, in welchem das Versiegeln des Schritts b) durch Applikation oder Ätzen eines auf dem Umfang jedes Chips definierten und möglicherweise auch in dem Zentralbereich jedes Chips applizierten Klebestreifens ausgeführt ist.

4. Das Verfahren gemäss Anspruch 1, in welchem die im Schritt d) eingesetzten elektrizitätsleitenden Verbindungen auf die Klötzen durch die Öffnungen vergossenen Metalldrähte aufweisen.

5. Das Verfahren gemäss Anspruch 1, in welchem die im Schritt d) eingesetzten elektrizitätsleitenden Verbindungen durch Applikation oder Ätzen einer Metallisierung gebildete Metalldrähte aufweisen, wobei genannte Metallisierung in Kontakt mit den Klötzen ist und sich auf dem Boden und auf den Flanken der Gräben erstreckt und von der Scheibe und der Haube elektrisch isoliert ist.

6. Das Verfahren gemäss Anspruch 1, in welchem die im Schritt d) eingesetzten elektrizitätsleitenden Verbindungen aus der Oberseite der Haube an auf der Peripherie des Bauelements verteilte Übertragunskontakte austreten.

7. Das Verfahren gemäss Anspruch 1, in welchem die im Schritt d) eingesetzten elektrizitätsleitenden Verbindungen aus der Oberseite der Haube an Punkte eines Verbundsmusters austreten, die an auf dem Zentralbereich des Bauelements verteilte Übertragungskontakte angrenzen.

8. Ein SMD-Bauelement mit einem eine äussere Einkapselung aufweisenden Chips, der seine Übertragung auf ein Substrat erlaubt, wobei genannte Einkapselung auf ihrer Oberfläche eine Vielzahl von durch das Einkapselungsmittel mit den gegenübereinander angeordneten und in der Dicke des Einkapselungsmittels eingebetteten Klötzen des Chips elektrisch verbundenen Aussenmetallisierungen trägt, wobei das eingekapselte Bauelement ein Bauelement des Typs SMD ist, welches in der Längsrichtung und der Querrichtung im Wesentlichen dieselben Abmessungen hat wie der Chip vor der Einkapselung, wobei im Bauelement der Chip auf seiner Oberfläche von einer Haube überzogen ist, wobei genannte Haube auf den Chip in vorbestimmten Bereichen letzteres vergossen ist und auch einen entlang wenigstens eine der Seiten des Klötze tragenden Bauelements gebildeten Graben (22) umfasst, und wobei die Einkapselung (34) auf der Haube und auf einem reduzierten Teil jener Oberfläche im Bereich des Grabens gebildet ist, **dadurch gekennzeichnet, dass**
- die Haube Öffnungen in der Verlängerung jedes der darunterliegenden Klötze (16) umfasst, wobei genannte Öffnungen Löcher sind, die durch die Haube von einer Seite zur anderen verlaufen und die einen Zugang zu den entsprechenden Klötzen erlauben,
- der Graben nur auf einem Teil der Dicke der Haube gebildet ist,
- alle verschiedenen Öffnungen in den Graben münden.

9. Das Bauelement gemäss Anspruch 8, in welchem die Haube mit der Scheibe gleichartig ist, auf welcher die Chips, insbesondere eine Siliziumscheibe, geätzt ist.

10. Das Bauelement gemäss Anspruch 8, in welchem die Haube durch einen auf dem Umfang jedes Chips und möglicherweise auch in dem Zentralbereich jedes Chips applizierten Klebestreifen vergossen ist.
